(19) **Europäisches Patentamt European Patent Office Office européen des brevets**

(11) **EP 4 254 520 B1**

(12) **FASCICULE DE BREVET EUROPEEN**

(45) Date de publication et mention
de la délivrance du brevet:
**15.01.2025  Bulletin 2025/03**

(21) Numéro de dépôt: **23165259.5**

(22) Date de dépôt: **29.03.2023**

(51) Classification Internationale des Brevets (IPC):
**H01L 33/14** (2010.01)     **H01L 33/38** (2010.01)
**H01L 33/00** (2010.01)

(52) Classification Coopérative des Brevets (CPC):
**H01L 33/14; H01L 33/385;** H01L 33/0062

(54) **DIODE ELECTROLUMINESCENTE A INJECTION ELECTRIQUE OPTIMISEE DEPUIS UNE ELECTRODE LATERALE**

LEUCHTDIODE MIT OPTIMIERTER ELEKTRISCHER INJEKTION AUS EINER LATERALEN ELEKTRODE

LIGHT EMITTING DIODE WITH OPTIMIZED ELECTRICAL INJECTION FROM A LATERAL ELECTRODE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:  **01.04.2022  FR 2203005**

(43) Date de publication de la demande:
**04.10.2023  Bulletin 2023/40**

(73) Titulaire: **Commissariat à l'Energie Atomique et aux Energies Alternatives 75015 Paris (FR)**

(72) Inventeurs:
- **VAUFREY, David**
  **38054 Grenoble Cedex 09 (FR)**
- **MAINDRON, Tony**
  **38054 Grenoble Cedex 09 (FR)**
- **LE MAOULT, Corentin**
  **38054 Grenoble Cedex 09 (FR)**

(74) Mandataire: **Brevalex Tour Trinity 1 B Place de la Défense 92400 Courbevoie (FR)**

(56) Documents cités:
CN-A- 104 157 767     US-A1- 2011 198 664
US-A1- 2021 126 157

## Description

## DOMAINE TECHNIQUE

L'invention concerne le domaine des LED (diodes électroluminescentes), et plus particulièrement celui des LED dont une des électrodes est réalisée sous la forme d'un contact latéral.

## ÉTAT DE LA TECHNIQUE ANTÉRIEURE

Une LED est généralement composée d'un empilement d'au moins deux matériaux semi-conducteurs de type de conductivité opposée, formant des couches de transport de porteurs de charge électrique, et insérés entre deux électrodes. Une zone de recombinaison, formant une zone active par exemple composée d'un ou plusieurs puits quantiques superposés, est présente entre les deux matériaux semi-conducteurs de type de conductivité opposée. Lorsqu'une tension est appliquée entre les deux électrodes, des porteurs de charge électrique sont injectés via lesdites électrodes dans l'empilement de semi-conducteurs, puis sont transportés dans les semi-conducteurs. Des électrons sont injectés depuis la cathode (électrode en contact avec le semi-conducteur de type n), alors que des trous sont injectés depuis l'anode (électrode en contact avec le semi-conducteur de type p). Des paires électron-trou peuvent alors se former dans la zone active de l'empilement, et générer des photons s'échappant de l'empilement de semi-conducteurs par une surface émissive de la LED qui se trouve généralement du côté de l'une des deux électrodes.

Afin de maximiser l'émission lumineuse de la LED, il convient de maximiser la surface émissive de celle-ci en réduisant le plus possible la surface occupée par l'électrode localisée du côté de la surface émissive. Le document FR 3 008 547 A1 décrit une LED dans laquelle l'électrode localisée du côté de la face émissive de la LED est réalisée sous la forme d'un contact électrique latéral, c'est-à-dire disposée contre une face latérale de l'empilement, libérant ainsi totalement la surface émissive de la LED.

US 2021/126157 A1 divulgue une autre structure LED de l'art antérieur.

D'autres améliorations existent également pour augmenter l'émission lumineuse d'une LED.

Par exemple, pour prévenir la diffusion de dopants dans la zone active de la LED, ce qui aurait pour conséquence de réduire sa capacité à convertir des paires électrons-trous en photons à la longueur d'onde souhaitée, il est connu d'introduire une couche semi-conductrice non dopée adjacente à la zone active, par exemple entre la zone active et la couche de semi-conducteur dopé n.

En outre, en particulier avec des LED à base de GaN, il est connu d'introduire une couche de blocage de porteurs adjacente à la zone active de la LED, dont le but est de confiner les porteurs concernés dans la zone active. On parle alors de couche de blocage d'électrons, ou « Electron Blocking Layer » (EBL) en anglais, ou de couche de blocage de trous, ou « Hole Blocking Layer » (HBL) en anglais. Ces couches se distinguent par leur intimité avec la zone active et par leur nature différente permettant de former une barrière s'opposant à la circulation des porteurs. Par exemple, dans une LED à base de GaN, une EBL composée d'AlGaN ou d'InAlGaN (dont le gap est plus grand que celui du GaN) peut être insérée entre la zone active et la couche de transport de trous à base de GaN dopé p.

Afin de limiter les défauts de croissance dans la zone active d'une LED, il est également connu de débuter la croissance du semi-conducteur de la LED sur un substrat de croissance (par exemple en silicium) par des couches épaisses et ou des alternances de couches de matériaux présentant des paramètres de maille différents et se rapprochant progressivement de celui du matériau de la zone active. Ainsi, de telles couches, appelées couches tampon ou couches buffer, permettent de compenser au moins en partie la différence de paramètre de maille entre le substrat de croissance et le semi-conducteur composant la zone active de la LED. Ces couches tampon ne sont pas électriquement actives (car elles ne sont pas traversées par un courant) et sont de plus non dopées électriquement. Dans le cas d'une LED de type VTF (« Vertical Thin Film » en anglais, ou couches minces verticales), les couches tampon sont éliminées pendant le procédé de réalisation de la LED.

En outre, l'efficacité d'une LED est le produit de plusieurs efficacités dont l'extraction, c'est-à-dire la probabilité pour un photon de s'échapper de l'empilement composant la LED. Différentes méthodes existent dans le but d'exacerber l'extraction, dont une en particulier qui consiste à réduire l'épaisseur de l'empilement de semi-conducteurs formant la LED de manière à générer des interférences constructives de type Fabry Perot et à limiter l'absorption optique de cet empilement.

Un positionnement judicieux des électrodes permet également de distribuer uniformément le courant dans la zone active de la LED. En effet, une distribution uniforme du courant dans la zone active de la LED accroit son efficacité car la densité de courant locale circulant dans la LED est minimisée. Différentes géométries d'électrode permettent de distribuer uniformément le courant dans la zone active de la LED.

L'amélioration de l'uniformité de distribution du courant dans la zone active de la LED est également obtenue en réalisant une couche de transport de charge (donc dopée) épaisse, et/ou en introduisant une couche dite de « spreading », ou d'étalement, caractérisée par une conductivité plus élevée que celle du semi-conducteur sur laquelle elle est formée. Cette interface entre ces deux matériaux de conductivité différente permet d'améliorer l'uniformité de distribution du courant.

Il s'avère complexe de satisfaire à la fois aux contraintes de l'optimisation de l'extraction et à celles de l'uniformisation de la distribution du courant qui sont contradictoires, en particulier dans les LED de faible épaisseur. En effet, pour optimiser l'efficacité d'une LED, il est indispensable d'optimiser l'extraction d'une LED. Or, pour optimiser l'extraction il est souhaitable de minimiser l'épaisseur de l'empilement semi-conducteur pour limiter l'absorption optique induite par les matériaux de la LED et pour se placer dans des conditions d'interférences lumineuses constructives. Parallèlement, pour distribuer le courant uniformément au travers de la zone active de la LED, et par conséquent atteindre les flux optiques les plus élevés, il est requis d'accroître l'épaisseur d'une couche de transport et/ou d'utiliser une couche de spreading et de la rendre la plus conductrice possible pour minimiser les pertes ohmiques.

Cette criticité est accrue par l'emploi d'une électrode réalisée sous la forme d'un contact électrique latéral. En effet, contrairement à une électrode planaire, c'est-à-dire une électrode formée sur un plan normal à la direction de croissance de l'empilement semi-conducteur, l'injection au travers d'une électrode latérale n'est pas uniforme puisque la densité de courant injectée est plus importante sur les parties de l'électrode les plus proches de la contre-électrode (et donc à priori de la zone active).

Par exemple, pour réaliser une LED comprenant une électrode latérale, les différentes couches de l'empilement sont tout d'abord réalisées sur un substrat de croissance. Une couche d'électrode est ensuite formée au sommet de l'empilement. Un substrat de report est ensuite solidarisé à la couche d'électrode puis le substrat de croissance est désolidarisé de l'empilement, par exemple par lift-off laser, ou chauffage adiabatique par des impulsions laser. La face de l'empilement libérée du substrat de croissance est ensuite gravée et polie. Une gravure est ensuite réalisée à travers l'empilement afin de former sur le substrat des structures mesa chacune destinées à former une LED. Un matériau diélectrique est ensuite déposé de manière conforme, recouvrant notamment les faces polies et les faces latérales des structures mesa. Une gravure anisotrope est ensuite mise en oeuvre pour supprimer le matériau diélectrique sur une épaisseur qui dépend du temps de gravure choisi, révélant ainsi les faces latérales des structures mesa sur l'épaisseur gravée. Les électrodes latérales sont ensuite réalisées en utilisant le matériau diélectrique restant comme support pour le dépôt du matériau électriquement conducteur formant les électrodes latérales.

La gravure anisotrope mise en oeuvre est toutefois délicate car :

- l'épaisseur de matériau diélectrique gravé dépend de la durée de mise en oeuvre de la gravure et non de la position d'une couche d'arrêt de gravure ;
- elle ne compense pas les non-uniformités induites par le polissage mis en oeuvre après le retrait du substrat de croissance.

La conséquence de ces difficultés est que la position de l'électrode latérale par rapport à l'autre électrode peut fluctuer de plusieurs centaines de nanomètres pour des LED réalisées sur des substrats différents. De plus, sur un même substrat, cette position varie également compte tenu de la dispersion de l'épaisseur de l'empilement semi-conducteur formé sur le substrat, causée en particulier par le polissage mis en oeuvre après la désolidarisation du substrat de croissance. Ces variations de la position de l'électrode latérale se traduisent par des variations sur l'injection des porteurs de charge électrique depuis l'électrode latérale, ce qui se répercute sur les performances de la LED

## EXPOSÉ DE L'INVENTION

Un but de la présente invention est de proposer une diode électroluminescente dont la structure permet de contrôler la position de l'injection de porteurs de charge électrique dans l'empilement de la diode électroluminescente depuis l'électrode latérale.

Pour cela, la présente invention propose une diode électroluminescente comprenant :

- une première électrode ;
- une première couche de semi-conducteur dopé selon un premier type de conductivité et comprenant une première face disposée du côté de la première électrode ;
- une deuxième couche de semi-conducteur dopé selon un deuxième type de conductivité, opposé au premier type de conductivité ;
- une région de recombinaison radiative de porteurs de charge électrique des premier et deuxième types de conductivité disposée entre, ou à l'interface de, une deuxième face, opposée à la première face, de la première couche et une première face de la deuxième couche ;
- une troisième couche de semi-conducteur dopé selon le deuxième type de conductivité ;
- une quatrième couche de semi-conducteur disposée entre une deuxième face, opposée à la première face, de la deuxième couche et la troisième couche ;
- une deuxième électrode disposée contre au moins une partie d'au moins une face latérale de la troisième couche et contre une partie seulement d'au moins une face latérale de la quatrième couche ;

et dans laquelle le semi-conducteur de la quatrième couche forme, par rapport au semi-conducteur de la troisième couche, une barrière énergétique d'au moins 100 meV s'opposant à une circulation de porteurs de charge électrique selon le deuxième type de conductivité depuis la deuxième électrode vers la deuxième couche.

Dans cette LED, la quatrième couche est insérée entre les deuxième et troisième couches de semiconducteur dopé selon le deuxième type de conductivité qui forment ensemble la couche de transport des charges électriques selon ce deuxième type de conductivité. La différence de barrière énergétique à l'interface entre le semi-conducteur de la quatrième couche et l'électrode latérale et le semiconducteur de la troisième couche et l'électrode latérale a pour conséquence que les charges électriques injectées depuis l'électrode latérale vont rentrer dans l'empilement semi-conducteur de la LED par la troisième couche, à proximité de l'interface formée avec la quatrième couche, et non par la quatrième couche. La présence de la quatrième couche au sein de la couche de transport de charges électriques permet donc de garantir l'endroit, ou la position, de l'empilement semi-conducteur au niveau duquel les charges électriques selon le deuxième type de conductivité sont injectées.

De plus, cette barrière énergétique entre les quatrième et troisième conduit également à un étalement des charges électriques dans la troisième couche avant leur passage à travers la quatrième couche pour atteindre la zone active de la LED, et ainsi uniformiser la densité de courant au sein de la LED.

L'insertion de la quatrième couche entre les deuxième et troisième couches dopées permet de positionner précisément la zone d'injection de porteurs de charge électrique depuis l'électrode latérale et permet d'effacer les non-uniformités d'épaisseur de l'empilement semi-conducteur induites par la réalisation de ou des LED .

La quatrième couche se distingue d'une couche de type EBL ou HBL car elle n'est pas en contact avec la zone émissive de la LED, c'est-à-dire avec la région de recombinaison radiative de porteurs de charge électrique.

La quatrième couche se distingue également des couches tampon car elle est traversée par un courant lorsque la LED est en fonctionnement.

La quatrième couche se distingue également d'une couche d'étalement car elle forme une barrière énergétique qui n'est pas obtenue avec une couche d'étalement, et elle est formée au cours des mêmes étapes que celles formant les deuxième et troisième couches.

L'invention s'applique avantageusement pour des LED de faible épaisseur, c'est-à-dire dont l'épaisseur totale est inférieure ou égale à environ 2 $\mu$m et préférentiellement 1$\mu$m.

Dans tout le document, le terme « LED » et l'expression « diode électroluminescente » sont utilisés pour désigner également des micro-LED.

La diode électroluminescente selon l'invention peut avantageusement être utilisée pour des applications nécessitant des diodes de faibles dimensions latérales et de faible épaisseur, par exemple pour la réalisation d'écrans de forte résolution, en particulier les applications de type projection intra-rétinienne.

Pour que le semi-conducteur de la quatrième couche forme, par rapport au semi-conducteur de la troisième couche, une barrière énergétique d'au moins 100 meV s'opposant à la circulation des porteurs de charge électrique selon le deuxième type de conductivité depuis la deuxième électrode vers la deuxième couche, il est par exemple proposé que :

- le semi-conducteur de la quatrième couche soit non dopé ou soit dopé selon le deuxième type de conductivité avec un niveau de dopage inférieur à celui du semi-conducteur de la troisième couche, et/ou
- la composition de l'alliage, ou composition atomique, du semi-conducteur de la quatrième couche soit différente de celle du semi-conducteur de la troisième couche.

De manière avantageuse, le premier type de conductivité peut correspondre au type p et le deuxième type de conductivité peut correspondre au type n.

La conductivité électrique de la troisième couche peut être supérieure à celle de la deuxième couche.

Selon un exemple de réalisation, la troisième couche peut comporter au moins deux sous-couches de conductivité croissante dans le sens allant de la quatrième couche vers la face émissive.

La deuxième électrode peut former une couronne entourant latéralement la troisième couche sur la totalité de de son épaisseur et entourant latéralement seulement une partie de la quatrième couche, ladite partie de la quatrième couche étant disposée contre la troisième couche. Dans cette configuration, en considérant qu'une première partie de la quatrième couche correspond à celle entourée par la deuxième électrode et qu'une deuxième partie de la quatrième couche correspond à celle qui n'est pas entourée par la deuxième électrode, alors la première partie de la quatrième couche est disposée entre la deuxième partie de la quatrième couche et la troisième couche, et la deuxième partie de la quatrième couche est disposée entre la première partie de la quatrième couche et la deuxième couche.

L'épaisseur des différentes couches de la LED correspond à la dimension de ces couches qui est, dans le cas d'une LED en forme de pavé, perpendiculaire aux interfaces formées entre ces couches.

Les semi-conducteurs des première, deuxième, troisième et quatrième couches peuvent être des semi-conducteurs III-V, comprenant par exemple du GaN, de l'InGaN, de l'AlGaN, de l'InAlGaN, du GaP, de l'AsGa, etc.

La région de recombinaison radiative de porteurs de charge électrique des premier et deuxième types de conductivité peut comporter un ou plusieurs puits quantiques chacun formé d'au moins une couche émissive semi-conductrice disposée entre au moins deux couches barrières semi-conductrices.

Dans une configuration particulière, la diode électroluminescente peut comporter en outre :

- une couche de semi-conducteur non dopé disposée entre la région de recombinaison radiative de porteurs de charge électrique des premier et deuxième types de conductivité et la deuxième couche, et configurée pour former une barrière de diffusion de dopants électriques, et/ou

- une couche de blocage des porteurs de charge électrique du second type de conductivité disposée entre la région de recombinaison radiative de porteurs de charge électrique des premier et deuxième types de conductivité et la première couche, et comprenant un semi-conducteur dopé selon le premier type de conductivité et dont le gap est supérieur à celui du semi-conducteur de la première couche.

Une telle couche de blocage peut être dopée P, ce qui lui permet de bloquer les électrons et se positionne entre la couche active et la couche de semi-conducteur dopé de type P. En variante, cette couche de blocage peut être dopée N, ce qui lui permet de bloquer les trous et se positionne entre la couche active et la couche de semi-conducteur dopé de type N.

L'invention concerne également un procédé de réalisation d'une diode électroluminescente comprenant :

- réalisation, sur un premier substrat, d'un empilement de couches incluant :

  a) une première couche d'électrode disposée sur le premier substrat ;
  b) une première couche de semi-conducteur dopé selon un premier type de conductivité et comprenant une première face disposée du côté de la première couche d'électrode ;
  c) une deuxième couche de semi-conducteur dopé selon un deuxième type de conductivité, opposé au premier type de conductivité ;
  d) une région de recombinaison radiative de porteurs de charge électrique des premier et deuxième types de conductivité disposée entre, ou à l'interface de, une deuxième face, opposée à la première face, de la première couche et une première face de la deuxième couche ;
  e) une troisième couche de semi-conducteur dopé selon le deuxième type de conductivité ;
  f) une quatrième couche de semi-conducteur disposée entre une deuxième face, opposée à la première face, de la deuxième couche et la troisième couche ;

- gravure de l'empilement telle que des portions restantes de l'empilement forme au moins une structure mesa ;
- dépôt conforme d'une couche diélectrique, recouvrant au moins une face supérieure et des faces latérales de la structure mesa ;
- gravure anisotrope d'une partie de l'épaisseur de la couche diélectrique, révélant au moins une partie d'au moins une face latérale de la troisième couche et une partie seulement d'au moins une face latérale de la quatrième couche ;
- réalisation d'une électrode, appelée deuxième électrode, contre ladite au moins une partie d'au moins une face latérale de la troisième couche et contre ladite partie d'au moins une face latérale de la quatrième couche ;

et dans lequel le semi-conducteur de la quatrième couche forme, par rapport au semi-conducteur de la troisième couche, une barrière énergétique d'au moins 100 meV s'opposant à la circulation de porteurs de charge électrique selon le deuxième type de conductivité depuis la deuxième électrode vers la deuxième couche.

La réalisation de l'empilement de couches peut comporter les étapes suivantes :

- épitaxie des première, deuxième, troisième et quatrième couches et de la région de recombinaison radiative sur un substrat de croissance, telle que la troisième couche soit disposée entre le substrat de croissance et la quatrième couche ;
- dépôt de la première couche d'électrode sur la première couche ;
- solidarisation de la première couche d'électrode au premier substrat qui correspond à un substrat de report ;
- désolidarisation de la troisième couche vis-à-vis du substrat de croissance ;
- gravure et planarisation mécano-chimique de la face de la troisième couche précédemment disposée contre le substrat de croissance.

Dans l'ensemble du document, le terme « sur » est utilisé sans distinction de l'orientation dans l'espace de l'élément auquel ce rapporte ce terme. Par exemple, dans la caractéristique « sur une face du substrat », cette face du substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

[Fig. 1] représente une vue en coupe d'une diode électroluminescente, objet de la présente invention, selon un mode de réalisation particulier.

[Fig. 2] représente des simulations de cartographie de densités de courant pour une diode électroluminescente selon la présente invention et pour d'autres diodes ne comportant pas de quatrième couche telle que spécifiée selon l'invention.

[Fig. 3A] à [Fig. 3F] représentent les étapes d'un procédé de réalisation de diode électroluminescente, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

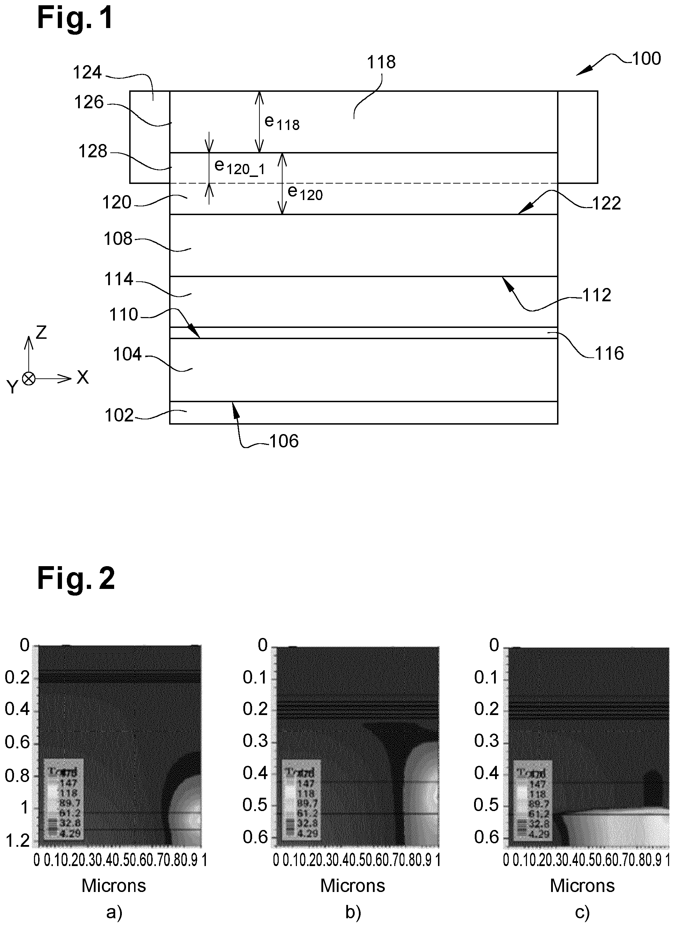

Une diode électroluminescente 100 selon un mode de réalisation particulier est décrite ci-dessous en lien avec la figure 1 qui représente une vue en coupe de cette diode 100.

La diode 100 comporte une première électrode 102 ainsi qu'une première couche 104 de semi-conducteur dopé selon un premier type de conductivité. La première couche 104 comprend une première face 106 disposée du côté de la première électrode 102.

Dans l'exemple de réalisation décrit ici, le premier type de conductivité correspond au type p. Ainsi, la première électrode 102 correspond à l'anode de la diode 100. En outre, selon cet exemple de réalisation, la première électrode 102 peut comporter au moins l'un des matériaux suivants : Ti, Ag, Cr, Al, TiN, W, Cu, Au, ITO (oxyde d'indium et d'étain). La première électrode 102 peut comporter une épaisseur comprise entre 10nm et $2\mu m$. De plus, dans cet exemple de réalisation, la première couche 104 comporte du GaN, ou plus généralement n'importe quel semi-conducteur III-V tel que de l'InGaN, de l'AlGaN, de l'InAlGaN, du GaAs, du GaP, etc. La première couche 104 peut comporter une épaisseur comprise entre par exemple 50 et 300 nm s'il s'agit de GaN dopé de type P. Le niveau de dopage du semi-conducteur de la première couche 104 est par exemple compris entre $1^e17$ et $5^e21$ atomes/$cm^3$.

La diode 100 comporte également une deuxième couche 108 de semi-conducteur dopé selon un deuxième type de conductivité, opposé au premier type de conductivité, c'est-à-dire de type n dans cet exemple de réalisation. En outre, selon cet exemple de réalisation, la deuxième couche 108 comporte du GaN, ou plus généralement n'importe quel semi-conducteur III-V tel que l'un de ceux précédemment mentionnés pour la première couche 104. Le semi-conducteur de la deuxième couche 108 peut être similaire ou non à celui de la première couche 104. La deuxième couche 108 peut comporter une épaisseur comprise entre 200 nm et 20 $\mu m$. Le niveau de dopage du semi-conducteur de la deuxième couche 108 est par exemple compris entre $1^e17$ et $5^e21$ atomes/$cm^3$.

La diode 100 comporte également, entre une deuxième face 110, opposée à la première face 106, de la première couche 104 et une première face 112 de la deuxième couche 108, une région 114 de recombinaison radiative de porteurs de charge électrique des premier et deuxième types de conductivité. Dans l'exemple de réalisation décrit ici, cette région 114 comporte un ou plusieurs puits quantiques chacun formé par au moins une couche émissive semi-conductrice non dopée disposée entre au moins deux couches barrières semi-conductrices. Les couches formant la région 114 comporte du semi-conducteur III-V. Par exemple, les couches barrière peuvent comporter du GaN, et les couches émissives peuvent comporter de l'InGaN.

Dans l'exemple de réalisation décrit ici, la diode 100 comporte également une couche 116 de blocage d'électrons disposée entre la région 114 et la première couche 104 (et contre la deuxième face 110 de la première couche 104) et comprenant un semi-conducteur, ici de type III-V, dopé selon le même type de conductivité que la première couche 104 (type p dans l'exemple de réalisation décrit ici) et dont le gap est supérieur à celui du semi-conducteur de la première couche 104. Par exemple, lorsque la première couche 104 comporte du GaN dopé p, la couche 116 de blocage d'électrons peut comporter de l'AlGaN dopé p ou de l'InAlGaN dopé p.

Selon une première variante, que la diode 100 comporte ou non la couche 116 de blocage d'électrons (ou de trous), il est possible que la diode 100 comporte une couche de semi-conducteur non dopé (non visible sur la figure 1) disposée entre la région 114 et la deuxième couche 108 (et contre la première face 112 de la deuxième couche 108) et configurée pour former une barrière de diffusion de dopants électriques. Cette barrière de diffusion peut comporter un semi-conducteur III-V, par exemple similaire à celui de la deuxième couche 108 (du GaN dans l'exemple de réalisation décrit ici).

Selon une deuxième variante, il est possible que la diode 100 ne comporte ni la couche 116 de blocage d'électrons ou de trous, ni la couche formant une barrière de diffusion de dopants.

Selon une troisième variante compatible avec les première et deuxième variantes exposées ci-dessus, il est possible que la région 114 ne comporte pas de puits quantique, mais corresponde simplement à l'interface entre la deuxième face 110 de la première couche 104 et la première face 112 de la deuxième couche 108.

La diode 100 comporte également une troisième couche 118 de semi-conducteur dopé selon le deuxième type de conductivité. Le semi-conducteur de la troisième couche 118 est par exemple similaire à celui de la deuxième couche 108, autant en termes de composition atomique (GaN dans l'exemple décrit ici) que de niveau de dopage.

La diode 100 comporte également une quatrième couche 120 de semi-conducteur disposée entre une deuxième face 122, opposée à la première face 112, de la deuxième couche 108 et la troisième couche 118.

La diode 100 comporte également une deuxième électrode 124 disposée contre au moins une partie d'au moins une face latérale 126 de la troisième couche 118 et contre une partie seulement d'au moins une face latérale 128 de la quatrième couche 120. De manière avantageuse, la deuxième électrode 124 forme une couronne entourant latéralement la troisième couche 118 sur la totalité de son épaisseur (sur la figure 1, l'épaisseur totale de la troisième couche 118 est appelée $e_{118}$) et entourant latéralement la quatrième couche 120 sur seulement une partie de son épaisseur (sur la figure 1, l'épaisseur totale de la quatrième couche 120 est appelée $e_{120}$, et celle de la partie de la quatrième couche 120 entourée par la deuxième électrode 124 est appelée $e_{120\_1}$). L'épaisseur de la deuxième électrode 124, appelée $e_{124}$ sur la figure 1, est égale à la somme de l'épaisseur totale de la troisième couche 118 et de l'épaisseur de la partie de la quatrième couche 120 entourée par la deuxième électrode 124 ($e_{124} = e_{118} + e_{120\_1}$, avec $e_{120\_1} < e_{120}$). Sur la figure 1, les épaisseurs correspondent aux dimensions parallèles à l'axe Z, et sont ici perpendiculaires aux faces 106, 110, 112 et 122 des couches de l'empilement réalisé.

Dans la diode 100, les deuxième, troisième et quatrième couches 108, 118, 120 forment ensemble la couche de transport de charges électriques selon le deuxième type de conductivité de la diode 100.

Le semi-conducteur de la quatrième couche 120 forme, par rapport au semi-conducteur de la troisième couche 118, une barrière énergétique d'au moins 100 meV s'opposant à la circulation des porteurs de charge électrique selon le deuxième type de conductivité depuis la troisième couche 118 vers la quatrième couche 120. Cette barrière énergétique a pour conséquence d'induire une différence de barrière énergétique entre la deuxième électrode 124 et la troisième couche 118 et entre la troisième couche 118 et la quatrième couche 120. L'injection de porteurs électriques étant alors défavorisée à l'interface entre l'électrode 124 et la troisième couche 118 en comparaison de celle à l'interface entre l'électrode 124 et la quatrième couche 120.

Selon un mode de réalisation de l'invention, la barrière énergétique formée entre les semi-conducteurs des troisième et quatrième couches 118, 120 est obtenue car le gap du semi-conducteur de la quatrième couche 120 est supérieur d'au moins 100 meV par rapport au gap du semi-conducteur de la troisième couche 118. Un tel gap peut être obtenu en réalisant ces troisième et quatrième couches 118, 120 telles que la composition d'alliage du semi-conducteur de la quatrième couche 120 soit différente de celle du semi-conducteur de la troisième couche 118 (par exemple en augmentant la proportion d'aluminium dans le semi-conducteur de la quatrième couche 120 par rapport au semi-conducteur de la troisième couche 118).

Selon un autre mode de réalisation de l'invention, la barrière énergétique formée entre les semi-conducteurs des troisième et quatrième couches 118, 120 est obtenue car le semi-conducteur de la quatrième couche 120 est non dopé ou dopé selon le deuxième type de conductivité avec un niveau de dopage inférieur à celui du semi-conducteur de la troisième couche 118.

Selon un autre mode de réalisation de l'invention, la barrière énergétique formée entre les semi-conducteurs des troisième et quatrième couches 118, 120 est obtenue en raison de la différence de dopage entre les semi-conducteurs des troisième et quatrième couches 118, 120, et en raison de la différence de composition d'alliage entre les semi-conducteurs des troisième et quatrième couches 118, 120.

Dans le cas d'une barrière énergétique due à une différence de dopage entre ces semi-conducteurs, cette différence de dopage peut s'exprimer par la relation :

[Math 1]

$$\Delta V = kT \ln\left(\frac{N_{118}.N_{120}}{n_i^2}\right)$$

avec $\Delta V$ correspondant à la hauteur de la barrière énergétique qui est supérieure ou égale à 100 meV, k la constante de Boltzman, T la température à laquelle se trouve la diode 100, $N_{118}$ la concentration en dopants ionisés dans le semi-conducteur de la troisième couche 118, $N_{120}$ la concentration en dopants ionisés dans le semi-conducteur de la quatrième couche 120, et $n_i$ la concentration en porteurs de charge électrique intrinsèques au semi-conducteur des troisième et quatrième couches 118, 120.

Dans le cas d'une différence de gap, entre les semi-conducteurs des troisième et quatrième couches 118, 120, due à une différence de composition atomique des semi-conducteurs, la valeur de cette différence de gap est fonction de la nature des semi-conducteurs utilisés pour former les couches 118, 120. Dans le cas de couches 118, 120 dopées n, avec la quatrième couche 120 formant alors une barrière vis-à-vis d'électrons, la différence de gap correspond à la somme de l'offset des bandes de conduction des semi-conducteurs de ces couches et de la courbure de ces bandes. Il est par exemple possible de calculer une approximation de cet offset des bandes de conduction en réalisant les étapes suivantes :

- déterminer le gap des semi-conducteurs des couches 118 et 120 lorsqu'ils sont intrinsèques, par exemple à l'aide d'une base de données répertoriant ce type de données, ou par calcul (voir par exemple le document A. Goyal et al., "Band gap bowing parameter in pseudomorphic AlxGa1-xN/GaN high electron mobility transistor structures", Journal of Applied Physics 117, 225702 (2015), qui traite de la variation de gap de GaN en fonction de sa composition en Al et de la contrainte dans la couche) puis
- calculer les niveaux des bandes de valence et de conduction de chaque semi-conducteur à partir des valeurs de gap précédemment déterminées, puis
- calculer la position du niveau de Fermi de chaque semi-conducteur pour en déduire les différences d'énergies entre la bande de valence ou de conduction et le niveau de Fermi de chaque semi-conducteur, puis
- calculer la différence entre les deux positions précédemment calculées et qui correspond à la valeur d'offset recherchée.

Ces calculs peuvent par exemple être mis en oeuvre à l'aide d'un logiciel de simulation tel qu'ATLAS proposé par la société Silvaco.

Les différents éléments de la diode 100 décrits ci-dessus sont réalisés sous la forme d'une structure mesa dont la section, dans un plan parallèle à chacune des interfaces entre ces éléments, est par exemple de forme rectangulaire. D'autres formes sont toutefois possibles.

Du fait que la deuxième électrode 124 soit en contact avec la troisième couche 118 et ne soit pas en contact avec la deuxième couche 108, et que le semi-conducteur de la quatrième couche 120 forme une barrière énergétique par rapport au semi-conducteur de la troisième couche 118, les porteurs de charge électrique amenés depuis la deuxième électrode 124 entrent dans l'empilement semi-conducteur de la diode 100 depuis la troisième couche 118, à proximité de l'interface avec la quatrième couche 120, et non directement depuis les faces latérales de la quatrième couche 120. Cette différence de gap et/ou de dopage entre les troisième et quatrième couches 118, 120 a également pour conséquence de répartir les porteurs de charge électrique dans la troisième couche 118 avant leur passage jusqu'à la deuxième couche 108 à travers la quatrième couche 120 qui forme une barrière pour le passage des porteurs depuis la troisième couche 118 vers la quatrième couche 120.

Ainsi, la quatrième couche 120 permet d'améliorer l'uniformité de la distribution du courant dans la zone active de la diode 100 mais également d'imposer la position du point de la deuxième électrode 124 par lequel la densité de courant maximale sera injectée dans l'empilement semi-conducteur de la diode 100.

La figure 2 représente plusieurs simulations de cartographie de densités de courant obtenues dans la diode 100 qui comporte un empilement semi-conducteur d'épaisseur totale égale à environ 0,6 µm (simulation portant la référence « c) »), ainsi que dans des diodes ne comportant pas la quatrième couche 120 et dont l'épaisseur est soit similaire à celle de la diode 100 simulée (simulation portant la référence « b) »), soit plus importante (simulation portant la référence « a) »). Pour ces trois simulations, la deuxième électrode 124 s'étend depuis le bas de l'empilement sur une épaisseur comprise entre les deux lignes horizontales noires visibles sur la partie inférieure de chacune des simulations.

Ces simulations montrent bien que la densité de courant la plus élevée injectée depuis la deuxième électrode 124 correspond au point de la deuxième électrode 124 le plus proche de la zone active (simulations a) et b)), sauf dans le cas de la diode 100 (simulation c)) dans laquelle la position de la densité de courant maximale est imposée par la position de la quatrième couche 120 au sein de la couche de transport de porteurs de charge formée par les deuxième et troisième couches 108, 118. Sur les simulations de la figure 2, les régions de l'empilement les plus claires correspondent aux régions où la densité de courant est la plus élevée. Autrement dit, l'introduction de la quatrième couche 120 dans la couche de transport permet d'imposer la position d'injection de la deuxième électrode 124 et par conséquent de relâcher les contraintes sur les étapes technologiques de réalisation de cette deuxième électrode 124.

La différence de gap et/ou de dopage entre le semi-conducteur de la quatrième couche 120 et celui de la troisième couche 118 permet en particulier de former une barrière à l'injection pour la partie de la deuxième électrode 124 en contact avec la quatrième couche 120, cette barrière étant absente ou réduite pour la partie de la deuxième électrode 124 qui est en contact avec la troisième couche 118.

Il convient de souligner que les trois LED dont la cartographie de la densité de courant est simulée et représentée sur la figure 2 présentent sensiblement les mêmes caractéristiques électriques courant = f(tension), ce qui signifie que l'introduction de la quatrième couche 120 au sein de la couche de transport de charges formée par les deuxième et troisième couches 108, 118 n'influe pas négativement sur le comportement électro-optique de la LED.

De préférence, la quatrième couche 120 est disposée au sein de la couche de transport dopée présentant la plus grande conductivité parmi les deux couches de transport dopées n et p de la diode 100, c'est-à-dire la couche de transport formant la couche dite de « spreading », ou d'étalement, au sein de la diode 100. Dans l'exemple de réalisation décrit précédemment, la quatrième couche 120 est disposée au sein de la couche de transport dopée n formée par les deuxième et troisième couches 108, 118. Dans le cas où les couches de transport sont de conductivité équivalente, la quatrième couche 120 peut indifféremment être formée dans l'une ou l'autre des couches de transport dopée, c'est-à-dire du coté anode ou du coté cathode (mais du côté où l'électrode est latérale).

L'exemple de diode 100 précédemment décrit correspond à une variante d'une diode de type VTF. En variante, la diode 100 peut correspondre à une variante d'une diode de type CC («Conventional Chip » en anglais, ou puce conventionnelle), ou FC (« Flip Chip » en anglais, ou puce retournée), ou bien encore TFFC (« Thin Film Flip chip » en anglais, ou puce retournée en couches minces).

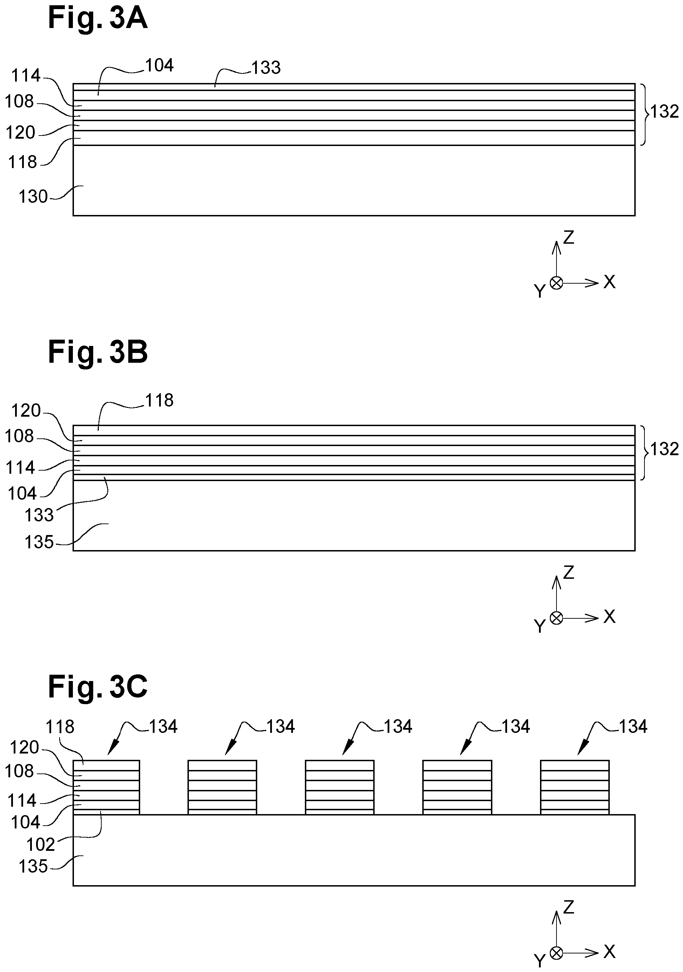

Un exemple de procédé de réalisation de diodes électroluminescentes 100 est décrit ci-dessous en lien avec les figures 3A à 3F.

Comme représenté sur la figure 3A, un empilement de couches 132 est réalisé sur un substrat de croissance 130 qui correspond par exemple à un wafer semi-conducteur. L'empilement 132 comporte ici :

- la troisième couche 118 disposée sur le substrat de croissance 130 ;
- la quatrième couche 120 disposée sur la troisième couche 118 ;
- la deuxième couche 108 disposée sur la quatrième couche 120 ;
- la région 114 de recombinaisons radiatives ;
- la première couche 104.

Les couches 118, 120, 108, 104 et la région 114 sont ici formées par épitaxie.

L'empilement 132 comporte également une première couche d'électrode 133 déposée sur la première couche 104.

La première couche d'électrode 133 est ensuite solidarisée à un premier substrat 135 qui correspond à un substrat de report. Cette solidarisation correspond par exemple à un collage métal - métal ou un collage direct.

La troisième couche 118 est ensuite désolidarisée vis-à-vis du substrat de croissance 130, par exemple par lift-off laser.

Une gravure et une planarisation mécano-chimique de la face de la troisième couche 118 précédemment solidarisée au substrat de croissance 130 sont ensuite mises en oeuvre. La structure obtenue à ce stade du procédé est représentée sur la figure 3B.

L'empilement 132 est ensuite gravé tel que des portions restantes de l'empilement forme des structures mesa 134, chacune destinée à former une LED (figure 3C). Chacune des structures mesa 134 comporte par exemple, dans un plan parallèle au plan (X, Y), une section de forme rectangulaire.

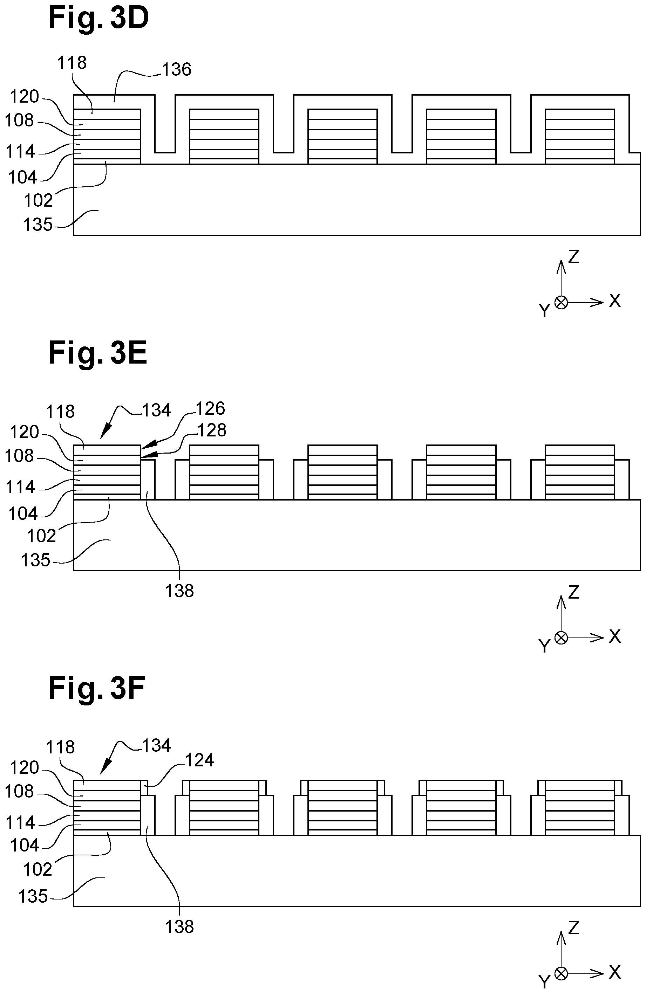

Une couche diélectrique 136 est ensuite déposée de manière conforme sur les structures mesa 134 et le substrat 135, recouvrant notamment les faces supérieures et les faces latérales des structures mesa 134 (figure 3D).

Une partie de l'épaisseur de la couche diélectrique 136 est ensuite gravée de manière anisotrope (figure 3E). Les portions restantes de la couche diélectrique 136 sont désignées par la référence 138. Cette gravure révèle, pour chaque structure mesa 134, les faces latérales 126 de la troisième couche 118 et une partie seulement des faces latérales 128 de la quatrième couche 120. Ainsi, au lieu de contrôler précisément la gravure de la couche diélectrique 136 et donc la hauteur précise des portions restantes de la couche diélectrique 136, l'épaisseur de la quatrième couche 120 offre une latitude de process directement proportionnelle à son épaisseur.

Pour chaque structure mesa 134, la deuxième électrode 124 est ensuite réalisée contre les faces latérales 126 de la troisième couche 118 et contre la partie des faces latérales 128 de la quatrième couche 120 révélées par la précédente gravure (voir figure 3F). Les deuxièmes électrodes 124 reposent sur les portions restantes diélectriques 138. Les deuxièmes électrodes 124 peuvent être réalisées par un dépôt conforme puis une gravure, ou par un dépôt de type ALD (dépôt en couche atomique) directement sur les flancs.

Il convient de souligner que la présente invention limite la criticité du procédé de fabrication des LED 100.

En effet, comme l'art antérieur l'enseigne, la distribution du courant dans une LED décrite par la longueur de spreading est directement proportionnelle à la racine de la distance minimale entre un point de l'électrode formée sur la couche de conductivité la plus élevée entre les couches 104 et 108 et un point de la zone active. Dans le cas d'une électrode latérale, l'injection s'effectue majoritairement par les portions de l'électrode les plus proches de la zone active (minimisation des pertes par effet Joule). Le spreading (donc la longueur de spreading) est contrôlé par la distance minimale entre un point de l'électrode latérale 124 et un point de la zone active.

Or, dans le cas de procédé de réalisation de LED mettant en oeuvre un report des couches semiconductrices sur un autre substrat (type VTF), cette distance n'est pas contrôlée ou contrôlable sur une même plaque mais aussi de plaque à plaque. En effet, le détachement des couches semiconductrices (couches 104, 114, 108, 120, 118) s'opère par des méthodes brutales telles que le lift off laser. Ce dernier consiste en l'échauffement adiabatique jusqu'à la fusion des dites une ou plusieurs couches comprises entre le substrat de croissance et les couches semi-conductrices réellement traversées par un courant pendant le fonctionnement de la future LED. L'échauffement et la fusion sont induits par l'absorption des dites couches d'impulsions laser. Il s'ensuit que la face libérée de l'empilement semiconducteur est profondément modifiée et rugueuse. Sur cette face et sur une profondeur non négligeable, le désordre est tel que de nombreux états dans le gap apparaissent et conduisent à une perte de transparence très conséquente. Hors, il s'agit de la face par laquelle les photons émis par la future LED devraient s'échapper.

Aussi, pour s'affranchir de ces défauts ou rugosité, une gravure pleine plaque est mise en oeuvre pour supprimer les matériaux de composition différente de celle des semi-conducteurs composant l'empilement LED, puis un polissage de cette face gravée est réalisé. Mais cette étape de polissage combinée à la gravure mentionnée ci-avant ne permettent pas de contrôler précisément l'épaisseur restante de l'empilement semi-conducteur et par voie de conséquence la distance détaillée ci-avant qui conditionne le spreading dans la LED. Il faut souligner que l'épaisseur restante et la distance qui conditionne le spreading ne peuvent être finement contrôlées de plaque à plaque mais également sur une même plaque, la CMP (polissage) induisant des variations d'épaisseur sur une même plaque basse fréquence. Dans ces conditions, l'efficacité des LED, dépendante du spreading, serait variable au sein de la même plaque et entre plaques.

En imposant le point d'injection des porteurs depuis l'électrode latérale, la présente invention réduit considérablement la criticité du procédé de fabrication pour obtenir des LED avec des caractéristiques électro-optiques similaires puisque la longueur de spreading est contrôlée.

Il appartiendra à l'homme de l'art d'adapter l'épaisseur $e_{120}$ de la couche 120 en fonction de la précision de son procédé de fabrication, puisque plus cette épaisseur est importante, plus les contraintes de procédé sont relâchées, avec toutefois en contrepartie qu'une épaisseur $e_{120}$ trop importante pourrait conduire à un décalage des tensions de fonctionnement de la LED.

L'invention est également particulièrement adaptée aux LED de petites dimensions latérales, souvent nommées μLED. Les LED de petites dimensions souffrent d'une efficacité réduite en particulier car :

- il est difficile de former une électrode sur la face émissive qui ne couvre pas une part importante de cette face émissive. L'efficacité de la μLED est donc fortement pénalisée par la faiblesse de son extraction ;

- les dimensions latérales réduites de la μLED entrainent que le comportement électro-optique de la μLED dépend beaucoup plus des effets de bord que pour les LED macroscopiques. En bord de la μLED, la gravure pour former des mesas (singularisation des μLED) a induit énormément de défauts dans le gap des semiconducteurs nécessaires aux recombinaisons non radiatives dites SRH (Shockley Read Hall). Les recombinaisons SRH concurrencent les radiatives et donc réduisent l'efficacité électro-optique de la LED. Dans le cas d'une LED munie d'une électrode latérale et en particulier si elle est de faible épaisseur (= faible longueur de spreading), les porteurs de charge se concentrent en périphérie de la LED (voir Fig 2 a et 2b), alimentent les défauts dans le gap donc les recombinaisons non radiatives ce qui conduit à une chute drastique de l'efficacité électro-optique de la LED.

La mise en oeuvre de la présente invention dans le cas des μLED assure une forte extraction puisque la face émissive n'est pas obstruée par une électrode et assure une distribution contrôlée des porteurs dans la zone active.

**REFERENCES CITEES**

**1 :** FR 3 008 547 A1

**2:** A. Goyal et al., "Band gap bowing parameter in pseudomorphic AlxGa1-xN/GaN high electron mobility transistor structures", Journal of Applied Physics 117, 225702 (2015).

**Revendications**

1. Diode électroluminescente (100) comprenant :

   - une première électrode (102) ;
   - une première couche (104) de semi-conducteur dopé selon un premier type de conductivité et comprenant une première face (106) disposée du côté de la première électrode (102) ;
   - une deuxième couche (108) de semi-conducteur dopé selon un deuxième type de conductivité, opposé au premier type de conductivité ;
   - une région (114) de recombinaison radiative de porteurs de charge électrique des premier et deuxième types de conductivité disposée entre, ou à l'interface de, une deuxième face (110), opposée à la première face (106), de la première couche (104) et une première face (112) de la deuxième couche (108) ;
   - une troisième couche (118) de semi-conducteur dopé selon le deuxième type de conductivité ;
   - une quatrième couche (120) de semi-conducteur disposée entre une deuxième face (122), opposée à la première face (112), de la deuxième couche (108) et la troisième couche (118) ;
   - une deuxième électrode (124) disposée contre au moins une partie d'au moins une face latérale (126) de la troisième couche (118) et contre une partie seulement d'au moins une face latérale (128) de la quatrième couche (120) ;
   et dans laquelle le semi-conducteur de la quatrième couche (120) forme, par rapport au semi-conducteur de la troisième couche (118), une barrière énergétique d'au moins 100 meV s'opposant à une circulation de porteurs de charge électrique selon le deuxième type de conductivité depuis la deuxième électrode (124) vers la deuxième couche (108).

**2.** Diode électroluminescente (100) selon la revendication 1, dans lequel :

   - le semi-conducteur de la quatrième couche (120) est non dopé ou est dopé selon le deuxième type de conductivité avec un niveau de dopage inférieur à celui du semi-conducteur de la troisième couche (118), et/ou
   - la composition de l'alliage du semi-conducteur de la quatrième couche (120) est différente de celle du semi-conducteur de la troisième couche (118).

**3.** Diode électroluminescente (100) selon l'une des revendications précédentes, dans laquelle le premier type de conductivité correspond au type p et le deuxième type de conductivité correspond au type n.

**4.** Diode électroluminescente (100) selon l'une des revendications précédentes, dans laquelle la conductivité électrique de la troisième couche (118) est supérieure à celle de la deuxième couche (108).

**5.** Diode électroluminescente (100) selon l'une des revendications précédentes, dans laquelle la deuxième électrode (124) forme une couronne entourant latéralement la troisième couche (118) sur la totalité de son épaisseur et entourant latéralement seulement une partie de la quatrième couche (120), ladite partie de la quatrième couche (120) étant disposée contre la troisième couche (118).

**6.** Diode électroluminescente (100) selon l'une des revendications précédentes, dans laquelle les semi-conducteurs des première, deuxième, troisième et quatrième couches (104, 108, 118, 120) sont des semi-conducteurs III-V.

**7.** Diode électroluminescente (100) selon l'une des revendications précédentes, dans laquelle la région (114) de recombinaison radiative de porteurs de charge électrique des premier et deuxième types de conductivité comporte un ou plusieurs puits quantiques chacun formé d'au moins une couche émissive semi-conductrice disposée entre au moins deux couches barrières semi-conductrices.

**8.** Diode électroluminescente (110) selon l'une des revendications précédentes, comportant en outre :

   - une couche de semi-conducteur non dopé disposée entre la région (110) de recombinaison radiative de porteurs de charge électrique des premier et deuxième types de conductivité et la deuxième couche (108), et configurée pour former une barrière de diffusion de dopants électriques, et/ou
   - une couche (116) de blocage de porteurs de charge électrique du deuxième type de conductivité disposée entre la région (114) de recombinaison radiative de porteurs de charge électrique des premier et deuxième types de conductivité et la première couche (104), et comprenant un semi-conducteur dopé selon le premier type de conductivité et dont le gap est supérieur à celui du semi-conducteur de la première couche (104).

**9.** Procédé de réalisation d'une diode électroluminescente (100) comprenant :

   - réalisation, sur un premier substrat (135), d'un empilement (132) de couches incluant :

      a) une première couche d'électrode (133) disposée sur le premier substrat (135) ;
      b) une première couche (104) de semi-conducteur dopé selon un premier type de conductivité et comprenant une première face (106) disposée du côté de la première couche d'électrode (133) ;
      c) une deuxième couche (108) de semi-conducteur dopé selon un deuxième type de conductivité, opposé au premier type de conductivité ;
      d) une région (114) de recombinaison radiative de porteurs de charge électrique des premier et deuxième types de conductivité disposée entre, ou à l'interface de, une deuxième face (110), opposée à la première face (106), de la première couche (104) et une première face (112) de la deuxième couche (108) ;
      e) une troisième couche (118) de semi-conducteur dopé selon le deuxième type de conductivité ;
      f) une quatrième couche (120) de semi-conducteur disposée entre une deuxième face (122), opposée à la première face (112), de la deuxième couche (108) et la troisième couche (118) ;

   - gravure de l'empilement (132) telle que des portions restantes de l'empilement (132) forme au moins une structure mesa (134) ;
   - dépôt conforme d'une couche diélectrique (136), recouvrant au moins une face supérieure et des faces latérales de la structure mesa (134) ;
   - gravure anisotrope d'une partie de l'épaisseur de la couche diélectrique (136), révélant au moins une partie d'au moins une face latérale (126) de la troisième couche (118) et une partie seulement d'au moins une face latérale (128) de la quatrième couche(120) ;

- réalisation d'une électrode, appelée deuxième électrode (124), contre ladite au moins une partie d'au moins une face latérale (126) de la troisième couche (118) et contre ladite partie d'au moins une face latérale (128) de la quatrième couche (120) ;

et dans lequel le semi-conducteur de la quatrième couche (120) forme, par rapport au semi-conducteur de la troisième couche (118), une barrière énergétique d'au moins 100 meV s'opposant à la circulation de porteurs de charge électrique selon le deuxième type de conductivité depuis la deuxième électrode (124) vers la deuxième couche (108).

10. Procédé selon la revendication 9, dans lequel la réalisation de l'empilement (132) de couches comporte les étapes suivantes :

- épitaxie des première, deuxième, troisième et quatrième couches (104, 108, 118, 120) et de la région (114) de recombinaison radiative sur un substrat de croissance (130), telle que la troisième couche (118) soit disposée entre le substrat de croissance (130) et la quatrième couche (120) ;
- dépôt de la première couche d'électrode (133) sur la première couche(104) ;
- solidarisation de la première couche d'électrode (133) au premier substrat (135) qui correspond à un substrat de report ;
- désolidarisation de la troisième couche (118) vis-à-vis du substrat de croissance (130) ;
- gravure et planarisation mécano-chimique de la face de la troisième couche (118) précédemment disposée contre le substrat de croissance (130).

**Patentansprüche**

1. Licht emittierende Diode (100), umfassend:

- eine erste Elektrode (102);
- eine erste Schicht (104) aus einem Halbleiter, der mit einem ersten Leitfähigkeitstyp dotiert ist und eine erste Fläche (106) umfasst, die auf der Seite der ersten Elektrode (102) angeordnet ist;
- eine zweite Schicht (108) aus einem Halbleiter, der mit einem zweiten Leitfähigkeitstyp dotiert ist, der dem ersten Leitfähigkeitstyp entgegengesetzt ist;
- eine Region (114) für die strahlende Rekombination von elektrischen Ladungsträgern des ersten und zweiten Leitfähigkeitstyps, die zwischen oder an der Grenzfläche einer zweiten Fläche (110) der ersten Schicht (104), die der ersten Fläche (106) gegenüberliegt, und einer ersten Fläche (112) der zweiten Schicht (108) angeordnet ist;
- eine dritte Schicht (118) aus einem Halbleiter, der nach dem zweiten Leitfähigkeitstyp dotiert ist;
- eine vierte Schicht (120) aus einem Halbleiter, die zwischen einer zweiten Fläche (122), die der ersten Fläche (112) gegenüberliegt, der zweiten Schicht (108) und der dritten Schicht (118) angeordnet ist;
- eine zweite Elektrode (124), die gegen mindestens einen Teil von mindestens einer seitlichen Fläche (126) der dritten Schicht (118) und nur gegen einen Teil von mindestens einer seitlichen Fläche (128) der vierten Schicht (120) angeordnet ist;

und wobei der Halbleiter der vierten Schicht (120) in Bezug auf den Halbleiter der dritten Schicht (118) eine Energiebarriere von mindestens 100 meV bildet, die einem Fluss von elektrischen Ladungsträgern nach dem zweiten Leitfähigkeitstyp von der zweiten Elektrode (124) zu der zweiten Schicht (108) entgegenwirkt.

2. Licht emittierende Diode (100) nach Anspruch 1, wobei:

- der Halbleiter der vierten Schicht (120) undotiert ist oder nach dem zweiten Leitfähigkeitstyp mit einem niedrigeren Dotierungsniveau als der Halbleiter der dritten Schicht (118) dotiert ist, und/oder
- die Legierungszusammensetzung des Halbleiters in der vierten Schicht (120) sich von der des Halbleiters in der dritten Schicht (118) unterscheidet.

3. Lichtemittierende Diode (100) nach einem der vorstehenden Ansprüche, wobei der erste Leitfähigkeitstyp dem p-Typ entspricht und der zweite Leitfähigkeitstyp dem n-Typ entspricht.

4. Lichtemittierende Diode (100) nach einem der vorstehenden Ansprüche, wobei die elektrische Leitfähigkeit der dritten Schicht (118) höher ist als die der zweiten Schicht (108).

5. Lichtemittierende Diode (100) nach einem der vorstehenden Ansprüche, wobei die zweite Elektrode (124) einen Kranz bildet, der die dritte Schicht (118) über ihre gesamte Dicke seitlich umgibt und nur einen Teil der vierten Schicht (120) seitlich umgibt, wobei der Teil der vierten Schicht (120) an der dritten Schicht (118) angeordnet ist.

6. Lichtemittierende Diode (100) nach einem der vorstehenden Ansprüche, wobei die Halbleiter der ersten, zweiten, dritten und vierten Schicht (104, 108, 118, 120) III-V-Halbleiter sind.

7. Lichtemittierende Diode (100) nach einem der vorstehenden Ansprüche, wobei die Region (114) der strahlenden Rekombination von elektrischen Ladungsträgern des ersten und zweiten Leitfähigkeitstyps einen oder mehrere Quantentöpfe umfasst, die jeweils aus mindestens einer emittierenden Halbleiterschicht gebildet sind, die zwischen mindestens zwei Halbleiterbarriereschichten angeordnet ist.

8. Lichtemittierende Diode (110) nach einem der vorstehenden Ansprüche, ferner umfassend:

   - eine undotierte Halbleiterschicht, die zwischen der Region (110) der strahlenden Rekombination von elektrischen Ladungsträgern des ersten und zweiten Leitfähigkeitstyps und der zweiten Schicht (108) angeordnet und so konfiguriert ist, dass sie eine Diffusionsbarriere für elektrische Dotierstoffe bildet, und/oder
   - eine Schicht (116) zum Blockieren von elektrischen Ladungsträgern des zweiten Leitfähigkeitstyps, die zwischen der Region (114) der strahlenden Rekombination von elektrischen Ladungsträgern des ersten und zweiten Leitfähigkeitstyps und der ersten Schicht (104) angeordnet ist und einen Halbleiter umfasst, der nach dem ersten Leitfähigkeitstyp dotiert ist und dessen Spalt größer als der des Halbleiters in der ersten Schicht (104) ist.

9. Verfahren zur Herstellung einer lichtemittierenden Diode (100), umfassend:

   - Herstellen, auf einem ersten Substrat (135), eines Stapels (132) von Schichten, einschließlich:

      a) eine erste Elektrodenschicht (133), die auf dem ersten Substrat (135) angeordnet ist;
      b) eine erste Schicht (104) aus einem Halbleiter, der mit einem ersten Leitfähigkeitstyp dotiert ist und eine erste Fläche (106) umfasst, die auf der Seite der ersten Elektrodenschicht (133) angeordnet ist;
      c) eine zweite Schicht (108) aus einem Halbleiter, der mit einem zweiten Leitfähigkeitstyp dotiert ist, der dem ersten Leitfähigkeitstyp entgegengesetzt ist;
      d) eine Region (114) für die strahlende Rekombination von elektrischen Ladungsträgern des ersten und zweiten Leitfähigkeitstyps, die zwischen oder an der Grenzfläche einer zweiten Fläche (110) der ersten Schicht (104), die der ersten Fläche (106) gegenüberliegt, und einer ersten Fläche (112) der zweiten Schicht (108) angeordnet ist;
      e) eine dritte Schicht (118) aus einem Halbleiter, der nach dem zweiten Leitfähigkeitstyp dotiert ist;
      f) eine vierte Schicht (120) aus einem Halbleiter, die zwischen einer zweiten Fläche (122), die der ersten Fläche (112) gegenüberliegt, der zweiten Schicht (108) und der dritten Schicht (118) angeordnet ist;

   - Ätzen des Stapels (132), sodass die verbleibenden Abschnitte des Stapels (132) mindestens eine Mesa-Struktur (134) bilden;
   - konformes Aufbringen einer dielektrischen Schicht (136), die mindestens eine obere Fläche und Seitenflächen der Mesa-Struktur (134) bedeckt;
   - anisotropes Ätzen eines Teils der Dicke der dielektrischen Schicht (136), wobei mindestens ein Teil von mindestens einer seitlichen Fläche (126) der dritten Schicht (118) und nur ein Teil von mindestens einer seitlichen Fläche (128) der vierten Schicht (120) freigelegt wird;
   - Herstellen einer Elektrode, die zweite Elektrode (124) genannt wird, gegen den mindestens einen Teil von mindestens einer seitlichen Fläche (126) der dritten Schicht (118) und gegen den Teil von mindestens einer seitlichen Fläche (128) der vierten Schicht (120);
   und wobei der Halbleiter der vierten Schicht (120) in Bezug auf den Halbleiter der dritten Schicht (118) eine Energiebarriere von mindestens 100 meV bildet, die dem Fluss von elektrischen Ladungsträgern nach dem zweiten Leitfähigkeitstyp von der zweiten Elektrode (124) zu der zweiten Schicht (108) entgegenwirkt.

10. Verfahren nach Anspruch 9, wobei die Herstellung des Stapels (132) von Schichten die folgenden Schritte umfasst:

   - Epitaxieren der ersten, zweiten, dritten und vierten Schicht (104, 108, 118, 120) und der Region (114) der strahlenden Rekombination auf einem Wachstumssubstrat (130), sodass die dritte Schicht (118) zwischen dem Wachstumssubstrat (130) und der vierten Schicht (120) angeordnet ist;
   - Abscheiden der ersten Elektrodenschicht (133) auf der ersten Schicht (104);
   - Befestigen der ersten Elektrodenschicht (133) an dem ersten Substrat (135), das einem Übertragungssubstrat entspricht;
   - Entkoppeln der dritten Schicht (118) von dem Wachstumssubstrat (130);
   - Ätzen und chemisch-mechanisches Planarisieren der Fläche der dritten Schicht (118), die zuvor gegen das Wachstumssubstrat (130) angeordnet wurde.

## Claims

1. A light-emitting diode (100) comprising:

   - a first electrode (102);
   - a first layer (104) of semiconductor doped to a first conductivity type and comprising a first face (106) arranged on the first electrode (102) side;
   - a second layer (108) of semiconductor doped to a second conductivity type, opposite to the first conductivity type;
   - a region (114) of radiative recombination of electric charge carriers of the first and second conductivity types arranged between, or at the interface of, a second face (110), opposite the first face (106), of the first layer (104) and a first face (112) of the second layer (108);
   - a third layer (118) of semiconductor doped to the second conductivity type;
   - a fourth layer (120) of semiconductor arranged between a second face (122), opposite the first face (112), of the second layer (108) and the third layer (118);
   - a second electrode (124) arranged against at least part of at least one side face (126) of the third layer (118) and against only part of at least one side face (128) of the fourth layer (120); and wherein the semiconductor of the fourth layer (120) forms, in relation to the semiconductor of the third layer (118), an energy barrier of at least 100 MeV against a flow of electric charge carriers of the second conductivity type from the second electrode (124) to the second layer (108).

2. The light-emitting diode (100) according to claim 1, wherein:

   - the semiconductor of the fourth layer (120) is non-doped or is doped to the second conductivity type with a doping level less than that of the semiconductor of the third layer (118), and/or
   - the alloy composition of the semiconductor of the fourth layer (120) is different from that of the semiconductor of the third layer (118).

3. The light-emitting diode (100) according to one of the preceding claims, wherein the first conductivity type corresponds to p-type and the second conductivity type corresponds to n-type.

4. The light-emitting diode (100) according to one of the preceding claims, wherein the electrical conductivity of the third layer (118) is greater than that of the second layer (108).

5. The light-emitting diode (100) according to one of the preceding claims, wherein the second electrode (124) forms a ring laterally surrounding the third layer (118) over its entire thickness and laterally surrounding only part of the fourth layer (120), said part of the fourth layer (120) being arranged against the third layer (118).

6. The light-emitting diode (100) according to one of the preceding claims, wherein the semiconductors of the first, second, third and fourth layers (104, 108, 118, 120) are III-V semiconductors.

7. The light-emitting diode (100) according to one of the preceding claims, wherein the region (114) of radiative recombination of electric charge carriers of the first and second conductivity types comprises one or several quantum wells each formed by at least one semiconductor emissive layer arranged between at least two semiconductor barrier layers.

8. The light-emitting diode (100) according to one of the preceding claims, further comprising:

   - a non-doped semiconductor layer arranged between the region (110) of radiative recombination of electric charge carriers of the first and second conductivity types and the second layer (108), and designed to form an electrical dopant diffusion barrier, and/or
   - a layer (116) for blocking electric charge carriers of the second conductivity type arranged between the region (114) of radiative recombination of electric charge carriers of the first and second conductivity types and the first layer (104), and comprising a semiconductor doped to the first conductivity type and the gap of which is greater than that of the semiconductor of the first layer (104).

9. A method for producing a light-emitting diode (100) comprising:

   - producing a stack (132) of layers on a first substrate (135) including:

     a) a first electrode layer (133) arranged on the first substrate (135);
     b) a first layer (104) of semiconductor doped to a first conductivity type and comprising a first face arranged on the first electrode layer (133) side;
     c) a second layer (108) of semiconductor doped to a second conductivity type, opposite to the first conductivity type;

d) a region (114) of radiative recombination of electric charge carriers of the first and second conductivity types arranged between, or at the interface of, a second face (110), opposite the first face (106), of the first layer (104) and a first face (112) of the second layer (108);
e) a third layer (118) of semiconductor doped to the second conductivity type;
f) a fourth layer (120) of semiconductor arranged between a second face (122), opposite the first face (112), of the second layer (108) and the third layer (118);

- etching the stack (132) such that remaining portions (132) of the stack (132) form at least one mesa-type structure (134);
- conformal deposition of a dielectric layer (136), covering at least an upper face and side faces of the mesa-type structure (134);
- anisotropic etching of part of the thickness of the dielectric layer (136), revealing at least part of at least one side face (126) of the third layer (118) and only part of at least one side face of the fourth layer (120);
- producing an electrode, named a second electrode (124), against said at least part of at least one side face (126) of the third layer (118) and against said part of at least one side face (128) of the fourth layer (120);
and wherein the semiconductor of the fourth layer (120) forms, in relation to the semiconductor of the third layer (118), an energy barrier of at least 100 MeV against the flow of electric charge carriers of the second conductivity type from the second electrode (124) to the second layer (108).

10. The method according to claim 9, wherein producing the stack (132) of layers comprising the following steps:

- epitaxy of the first, second, third and fourth layers (104, 108, 118, 120) and of the region (114) of radiative recombination on a growth substrate (130), such that the third layer (118) is arranged between the growth substrate (130) and the fourth layer (120);
- deposition of the first electrode layer (133) on the first layer (104);
- securing the first electrode layer (133) to the first substrate (135) which corresponds to a transfer substrate;
- removing the third layer (118) from the growth substrate;
- etching and chemical-mechanical polishing of the face of the third layer (118) previously arranged against the growth substrate (130).

## Fig. 1

## Fig. 2

a)

b)

c)

# Fig. 3A

# Fig. 3B

# Fig. 3C

# Fig. 3D

# Fig. 3E

# Fig. 3F

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3008547 A1

- US 2021126157 A1

**Littérature non-brevet citée dans la description**

- **A. GOYAL et al.** Band gap bowing parameter in pseudomorphic AlxGa1-xN/GaN high electron mobility transistor structures. *Journal of Applied Physics*, 2015, vol. 117, 225702